# EUROPEAN PATENT APPLICATION

(11) **EP 2 741 241 A1**
(43) Date of publication of application: **11.06.2014**
(21) Application number: 12306557.5
(22) Date of filing: 10.12.2012
(51) Int. Cl.: G06K 19/077, G06K 19/073, G06K 7/00

(54) **A Chip Module having a Protective Layer**

(71) Applicant: Oberthur Technologies, 92700 Colombes (FR)
(72) Inventor: Morin, Nicolas, 92700 COLOMBES (FR); Giraud, Christophe, 92700 COLOMBES (FR); Bosquet, Olivier, 92700 COLOMBES (FR)
(74) Representative: Santarelli

(57) **Abstract**

A chip module (1) comprising a chip (10) and a contact plate (6) in communication with said chip (10), further comprising a protective layer (15) positioned between the contact plate (6) and the chip (10).

## Description

### Field of the Invention

The current invention relates to a chip module comprising a protective layer. The current invention also relates to a data carrier including said chip module. Such a protective layer is intended to provide resistance to physical and/or chemical attacks attempting to access a chip module of e.g. a smart card.

### Background of the Invention

A smart card is typically a laminated card which has an electronic chip module incorporated in the body of the card to allow for communication with other devices such as payment or banking systems. Data held on the card, typically about the bearer of the card can be transmitted from the card to the third party device.

To manufacture a data carrier such as a smart card, a chip module has to be incorporated very precisely in the card so that it cannot be easily removed. Also during manufacture, where the chip module is embedded in the card, there needs to be precise positioning of the chip module with contacts that are embedded in the card so communication can occur. To incorporate a chip module in a card, firstly the card which provides the support body for the chip module is machined so that a recess is formed for receiving the chip module in the card and then the chip module is glued in place in the recess.

Due to the sensitive nature of the information that may be stored on chip modules in smart cards it may be necessary to protect these devices from reverse engineering in the event that a system containing them were to fall into the wrong hands. Typically, persons wanting to gain information or corrupt a smart card use a physical or chemical attack to remove the contact plate on the outside surface of a card and then they use a laser to cause a fault in the chip. The physical or chemical attack is typically drilling onto a contact plate on the surface of a card to remove it and then dissolving the adhesive that holds a chip in place so that it can be accessed by a laser or so it can be removed.

Typically, the security of a chip has been enhanced by providing a shield on the active surface of the chip. In US 2012/0088338 the chip is coated in a silicate glass material that has nano-particles in it to form a high durability coating. This coating is used to protect against laser attack of the chip but there is still the risk that a chip may be attacked by damage to the contact plate with which the chip interacts with external devices. To date coatings have been considered for protecting contact plate but there is the problem that the more layers there are covering the contact plate, the more risk there is that communication with external devices is compromised.

The present invention seeks to overcome the problems with the prior art by providing a low-cost simple way of preventing attack of a chip by way of damaging a contact plate while still preserving the ability of a data carrier to communicate effectively with external devices.

### Summary of the Invention

According to a first embodiment of the invention there is provided a chip module comprising a chip and a contact plate in communication with said chip, said chip module further comprising a protective layer positioned between the contact plate and the chip.

Advantageously, said protective layer is formed from a material that is harder than the contact plate and which is resistant to cutting and/or chemical degradation, thereby providing protection against access to the chip via the contact plate.

Preferably said protective layer is provided as a ceramic material, a reinforced glass material, a material containing silica or mica or a combination or said materials. Preferably said protective layer is provided as a separate discrete layer that is secured to the chip by an adhesive.

In an alternative arrangement, said protective layer includes particles of ceramic, glass and/or silica or mica, that are incorporated in abinder thereby forming an adhesive layer that to secure the chip to the contact plate.

It is envisaged that the contact plate has a recess to receive said protective layer.

Preferably the protective layer comprises apertures through with conductive tracks can extend to provide contact between the contact plate and the chip.

It is envisaged that the chip module is made of a glass epoxy having two faces, one face being metallized and which has been etched to provide contact tracks for the chip module and the second face which form the contact plate and has output pads able to provide the contact between the chip and an external device such as a data carrier reader.

In a preferred arrangement an active face of the chip is angled with respect to an outer face of the contact plate.

It is envisaged that the outer face of the contact plate is opposed to the active face of the chip, and that the chip is adhered to the contact plate using a layer which is thicker in one area than another area so that the active face of the chip is angled with respect to the outer face of the contact plate.

In an alternative arrangement, the chip module further comprises a chip support member comprising a first face able to be attached to the contact plate, and a second face angled with respect to the first face, able to be attached to the chip, so that the chip is held angled with respect to the contact plate.

Preferably the angle at which the chip is angled relative to the contact plate is more than 0 degrees, preferably between 1 and 15 degrees and more preferably is at a maximum of 10 degrees to the contact plate.

It is envisaged that the chip module may be covered by an encapsulate that conforms to the dimensions of a recess intended to receive said chip module, so the chip module can be push fitted into the recess.

Preferably the encapsulate comprises a resin epoxy cresol novolac with one or more fillers based on amorphous or crystalline silica and alumina.

It is envisaged that the protective layer may comprise at least one profiled face either to reflect a laser directed at said profiled face of the protective layer or to deflect a physical attack such as a drill applied to a said profiled face of the protective layer.

Preferably, the profiled face of the protective layer comprises a mirrored surface on at least part of said profiled face.

According to further embodiment of the invention there is provided a data carrier comprising a support body and a chip module, according to the previous embodiments, incorporated therein.

The invention involves seeks to overcome problems associated with the prior art by providing a protective layer that is associated with a chip module between the contact plate and the chip in order to resist attack of the chip via damage to the chip by axis through the contact plate.

### Brief Description of the Figures

An embodiment of the invention will now be described by way of example only with reference to the accompanying figures in which:
Figure 1 shows: a plan view of a contact plate that is associated with a chip module according to an embodiment of the invention;
Figure 2 shows: a sectional view of a contact plate and protective layer according to an embodiment of the invention;
Figure 3 shows: a sectional view of a chip module with a protective layer where conductive tracks are present joining the contact plate and chip;
Figure 4 shows: a sectional view of a chip module where conductive tracks extend through the protective layer;
Figure 5 shows: a sectional view of a chip module according to figure 2 embedded in a support body;
Figure 6 shows: a chip module where the protective layer is contained within a recess in the contact plate;
Figure 7 shows: a chip module embedded in a support body where the chip is angled with respect to the contact plate;
Figure 8: shows a chip module embedded in a support body where the protective layer and the adhesive are provided as an integral layer; and
Figure 9: shows a protective layer with a profiled surface.

### Detailed Description of Embodiments of the Invention

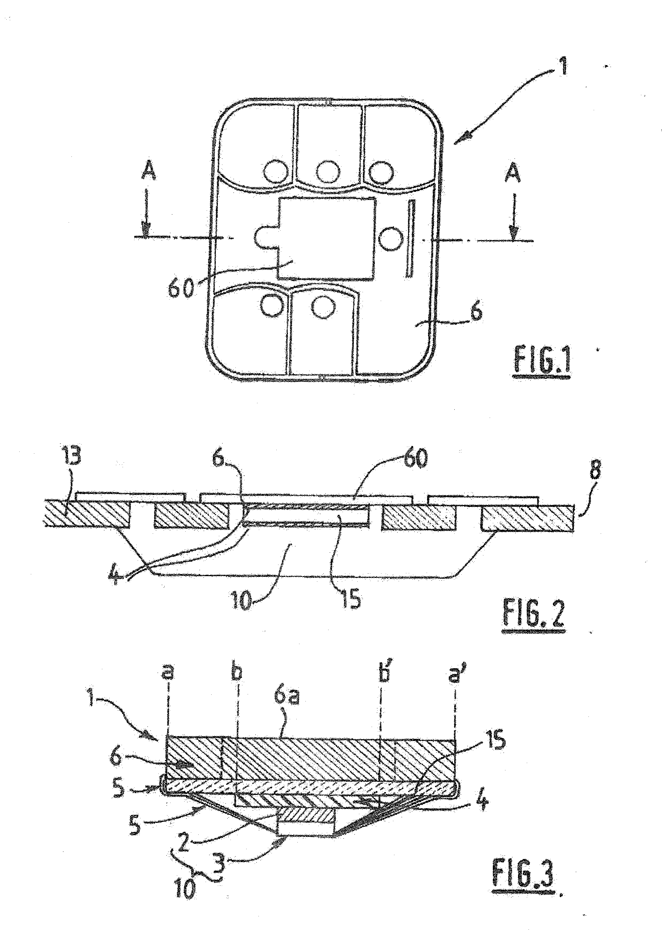

A chip module 1 generally has a contact plate 6 as shown 1 in **Figure 1****,** with a central region 60 where a chip 10 is located in a support body 8 such as a smart card. The outer face 6a of the contact plate 6 is generally level with that of the outer face of a support body 8 (such as a smart card) with the chip 10 being embedded in a recess 9 in the support body 8. As the contact plate 6 is exposed, it may be vulnerable to damage or attack by counterfeiters and if they can get at the contact plate 6 they may be able to get access to the chip 10 itself.

**Figure 2** shows the arrangement of Figure 1 where the contact plate 6 is shown as being embedded in a support body 8 and beneath the central region 60 of the contact plate 6 there is a protective layer 15. Said protective layer 15 is advantageously of a harder material than the contact plate 6, the contact plate 6 being generally copper based. On either side of the protective layer 15 there are adhesive layers 4 which hold the protective layer 15 in a fixed position against the contact plate 6 and a chip 10 that is contained within the support body 8. There are also epoxy layers 13 that provide adhesive support for the contact plate 6 in the support body 8 and also which help to provide a seal between the contact plate 6 and the card body so that there is no ingress of debris into the area where the chip 10 is held in the support body 8.

**Figure 3** shows more detail of the chip module 1 and as can be seen it is formed of a microprocessor chip 10 having a silicon body 2 with an etched (or active surface) face 3 (collectively referred to as a chip 10). The microprocessor chip 10 is held on a chip support 6 by way of an adhesive layer 4. Contact track or connectors 5 lead from the active face 3 to a contact plate 6 which can be positioned on a support body 8, which typically is a payment card such as a credit card. Between the adhesive layer 4 that adheres the chip 10 to the contact plate 6 and the contact plate 6 itself, there is a protective layer 15 which can extend (as shown) over an entire surface of the contact plate 6 that faces the chip 10 and this is shown as (a to a') or the protective layer 15 may extend over just the area that of the contact plate 6 that corresponds to the dimension of the chip 10 i.e. b to b'. In the arrangement shown conductive tracks 5 that connect the active face 3 of the chip 10 and the contact plate 6 extend around the protective layer 15. The active face 3 of the chip 10 is preferably opposed to the outer face 6a of the contact plate 6.

To clarify, in this embodiment and all other embodiments, typically the contact plate 6 is located on an outside surface of the card so there is the ability for the card to communicate with an external device. The chip module 1 is located internally in the card and is attached to the surface 6b of the contact plate 6 that is opposed to the outer face 6a. The card preferably is a bank card or other card that can identify a user that is trying to access a network such a telecommunication network. Typically such cards comply with ISO 7816.

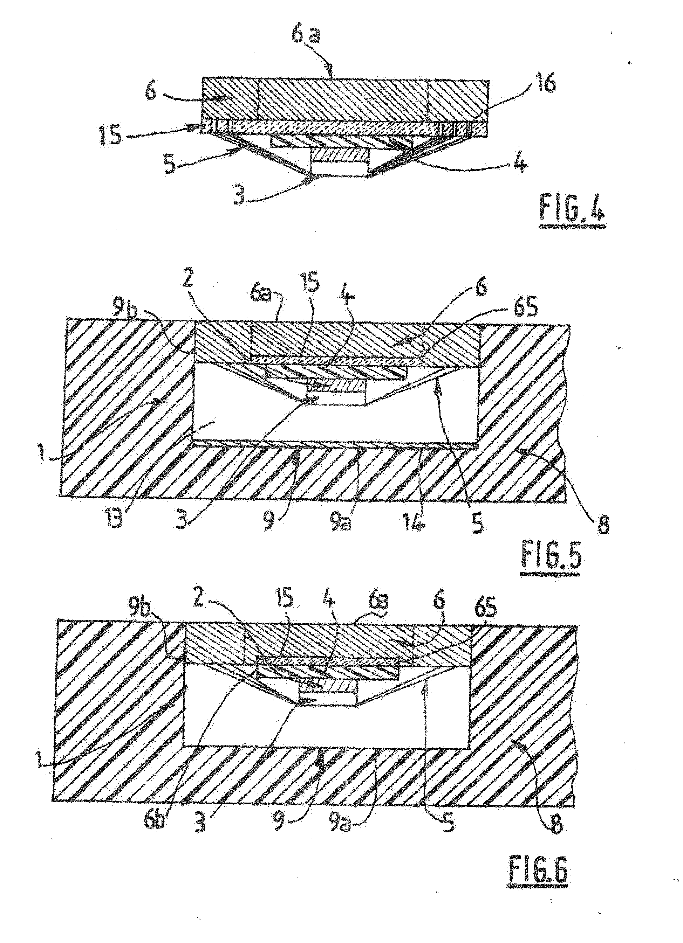

In **Figure 4** we see a similar arrangement as shown in Figure 2 except that in this arrangement the protective layer15 has a series of apertures 16 extending through the protective layer 15 and the conductive tracks 5 pass through the apertures 16 so connecting the active surface 3 of the chip and the contact plate 6. This makes for a further feature that resists corruption because if the contact plate 6 is prised off a support body 8 then there is a risk of breaking the conductive tracks 5 which would limit any communication between the chip 10 and the contact plate 6. There are areas of resin, such as an epoxy based resin which provide further protective layers under the contact plate 6 and which also support the contact plate 6 in the support body 8.

**Figure 5** shows the chip module 1 of Figure 1 embedded in a support body 8 which is in this case a smart card such as a bank card or credit card. The contact plate 6 has a chip 10 with an active surface 3 mounted on it. Contact track/connectors 5 are located between the active surface 3 and the contact plate 6. The chip module 1 and connectors 5 are encapsulated in a resin 13 and then this encapsulated body is positioned in a recess 9 in the support body 8. The encapsulated module is held in the recess 9 by adhesive layer 14 which is located at the base 9a of the recess 9. The chip 10 usually is connected to contact plate 6 by an adhesive layer 4. The adhesive layer 4 is typically based on epoxy-based polymer. Following initial bonding of the chip 10 on the contact plate 6, the chip 10 is encapsulated in resin 13 sets. The use of resin molding is used for packaging "classic" integrated circuits (eg DIPs). This resin 13 is a composite polymer such as epoxy cresol novolac generally plus mineral filler based on amorphous or crystalline silica and alumina. This use of resin 13 encapsulation has the advantage that is forms a sealed body around the chip 10 so the chip 10 is more resistant to chemical attack (e.g. based on methylene chloride) and prevents an attacker from accessing the chip 10 to corrupt it. This is because the resin 13 is much more resistant to being dissolved than the adhesives used in chip module manufacture.

The resin coating 13 that is used produces tightly adhering hermetic (water impermeable) coatings capable of withstanding very high temperatures. The resin coating 13 may be composed of alkali silicate glass with nanoparticle and or microparticle modifiers, including, but not limited to, alkaline earth carbonates or oxides, metal oxides, rare-earth metal oxides, and non-metal oxides. Aqueous alkali silicate composite solutions applied on or between surfaces of materials, dry to form tough, tightly adhering inorganic bonds that exhibit many desirable characteristics.

Other particles such as but not limited to diamond, aluminum nitride, and other inorganics may also be combined with aqueous alkali silicate based solutions and cured to form very hard and durable composites. Varying combination and concentrations of the various particles allows the production of composites with specific thermal expansion, durability, and adhesion properties. These composites have been shown to bond very well to integrated circuit materials, including but not limited to silicon, silica, silicon nitride, metals, and other inorganics. These alkali silicate glass coatings are very hard and corrosion resistant, making them extremely difficult to remove. Accordingly, it is desirable to add micro- and nano-particles to create a very hard glass composite coating that is difficult, impossible, or nearly impossible to mechanically remove without damaging the underlying chip 10t. Therefore, many applications exist for utilizing these composites for reverse engineering protection of chip 10, integrated circuits and/or electronics packages.

The support body 8 is any type of body that carries data, such as a passport, an identity card or even a card that holds personal data such as a driving license. The chip module 1 is held in a recess 9 in the support body 8 with the recess 9 having a base 9a and side walls 9b. Once in situ in the recess 9 the chip module 1 is typically encased in a protective shield layer such as a resin encapsulate 13. The contact plate 6 and the microprocessor chip 10 are parallel to one another when placed in the support body 8 and there is an external face 6a of the contact plate 6 that is on an outer surface of the support body 8 and an inner face that faces the inner part of the support body 8. The inner face 6b has protective layer 15 between it and the adhesive layer 4 that hold the chip 10 on the contact plate 6.

**Figure 6** shows a similar arrangement to that in Figure 5 except that the protective layer 15 is located in a recess 65 in the face 6b of the contact plate 6 that extends into the inner part of the support body 8. The contact plate 6 is connected to the chip 10 by adhesive layer 4 that is between the chip 10 and the contact plate 6. The chip 10 extends into a recess 9 in the support body 8 and an encapsulate 13 is contained in the recess 9 and the chip and contacts 5 are embedded in this encapsulate 13.

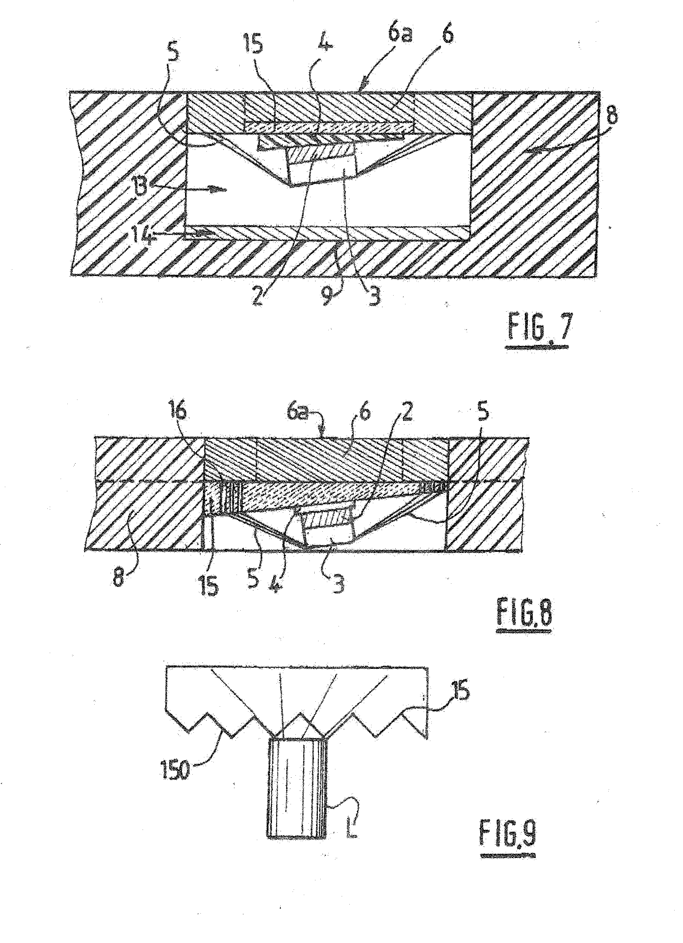

In **Figure 7**, we see a variation where the chip 10 is positioned at an angle to the contact plate 6. The contact plate 6 lies along a plane, which corresponds to that of an outer surface of a support body 8. It is envisaged that a face 3 of the chip 10 is angled with respect to this plane. The adhesive layer 4 is a varying depth which results in the layer 2 of the chip 10 resting at an angle and these results in the active face 3 of the chip 10 also being at an angle to the contact plate 6. The angle is typically between 0 to 15 degrees and more typically 8 to 12 degrees and more preferably 10 degrees. The chip module 1 may be encased in a resin 13 and the whole chip module 1 is adhered in the support body 8 using an adhesive layer 14 in the base of a recess 9 in the support body 8. Between the contact plate 6 and the adhesive layer 4 that attaches the contact plate 6 to the chip 10 there is a protective layer 15. The protective layer 15 prevents damage to the chip 10 by way of removing the contact plate 6 while if an attacker directs a light beam such as a laser through the face of the support body 8 opposite to that where the contact plate 6 is located then as the light that strikes the chip 10 is at an angle to that active face 3 of the chip 10, the light is deflected and deformation of the beam occurs so reducing its impact. Instead of having a small round spot, the beam spreads to form an oval (this is called "spread" beam). As a consequence of beam spreading it loses power density (W / m²), and this reduces the intensity of light and reduces the disruption of photons so rendering the chip module 1 less prone to attack.

As an alternative to an adhesive layer 4 forming an inclined surface for the chip 10 it may be that the protective layer 15 is itself profiled to have an incline so that when a chip 10 is glued to it, the chip 10 is held at an angle to the contact plate 6 so that the active surface 3 of the chip 10 can deflect light attacks. In addition the surface of the protective layer 15 that is adjacent the chip 10 may be angled or mirrored again to reflect attacks by light sources such as lasers and such features, together with the use of protective layers 15 provide a defense against attacks on the chip 10 from both sides.

It is envisaged that the protective layer 15 is of a material that is temperature resistant, e.g. it has a thermal stability up to 1000°C for example. In addition the material used should be resistant to drilling or cutting. It is preferred also that the protective layer 15 is opaque to laser beams and may include light reflective or absorbing particles such as silicates, calcium carbonates (chalk) carbon black or glass fibres or a mixture of such materials. In addition it is envisaged that the conductive tracks 5 for the chip 10 are contained within the recess 9 which the chip 10 is placed in the support body 8 so that if the centre pad 60 of the contact plate 6 is peeled back then any connections between the chip 10 and the contact plate 6 will be broken making the chip 10 non-functional and so useless to any counterfeiters.

It is possible that the adhesive 4 and the protective layer 15 may be combined in one layer. Ceramic particles that provide protection against drilling (or other particles such as glass or Kevlar ®) that are resistant to physical damage may be incorporated in an adhesive which itself is resistant to impact or abrasion as well as thermal damage. Such adhesives include acrylics or polyacrylics and the amount of particulate included in the polymer or even glass binder can affect the hardness of the layer and hence its resistance to drilling. This single layer is shown in **Figure 8** as 15 and like in Figure 7 the surface of the protective layer 15 is inclined so the active face 3 of the chip 10 is held at an angle. However it may be that the protective layer 15 has parallel faces and the chip 10 is attached to a profiled block that is attached to the protective layer 15 or indeed part of a face of protective layer 15 is raised and inclined while the reminder of the protective layer 15 has parallel faces so that the chip 10 is held at an angle to the contact plate 6 in a within the central part of the contact plate 6. As shown conductive tracks 5 pass through apertures 16 in the protective layer 15 to that the chip 10 and contact plate 6 are in conductive communication.

Finally, as shown in **Figure 9**, the protective layer 15 may have a profiled face 150 which is used to reflect laser light directed at the surface of the protective layer 15. The reflective profiled face 150 may either be on the side of the protective layer 15 that faces the chip 10 and when positioned in this location the profiled face 150 may assist in reflecting lasers that are used to corrupt the chip 10. Alternatively (or in combination) the profiled face 150 may be on the face of the protective layer 15 that is in proximity to the contact plate 6 and if an attempt is made to corrupt the chip 10 from the front face of the support body 8, then the profiled face 150 again will assist in deflecting laser light and reducing its impact on the chip 10. The profiled face 150 may also have at least on mirrored surface to reflect light or at least one hardened surface to deflect a drill bit that is aimed at the protective layer 15.

The use of the protective layer 15 provides a cost effective and technically effective way of stopping a counterfeiter gaining access to a microchip 10 on a support body 8 such as a data carrier. Further, in combination with a chip 10 having features to deflect attack by lasers, a particularly secure chip module 1 and data carrier including such features is obtained.

It is to be understood that the above embodiments have been provided only by way of exemplification of this invention, such as those detailed below, and that further modifications and improvements thereto, as would be apparent to persons skilled in the relevant art, are deemed to fall within the broad scope and ambit of the present invention described. Furthermore where individual embodiments are discussed, the invention is intended to cover combinations of those embodiments as well. The systems shown and described are not limited to the precise details and conditions disclosed. Method steps provided may not be limited to the order in which they are listed but may be ordered any way as to carry out the inventive process without departing from the scope of the invention. Furthermore, other substitutions, modifications, changes and omissions may be made in the design, operating conditions and arrangements of the exemplary embodiments without departing from the scope of the invention as expressed in the appended claims.

## Claims

1. A chip module (1) comprising a chip (10) and a contact plate (6) in communication with said chip (10), ***characterised in that*** said chip module (1) further comprises a protective layer (15) positioned between the contact plate (6) and the chip (10).

2. The chip module (1) according to claim 1, wherein said protective layer (15) is formed from a material that is harder than the contact plate (6) and which is resistant to cutting and/or chemical degradation.

3. The chip module (1) according to any one of claims 1 or 2, wherein said protective layer (15) is provided as a ceramic material, a reinforced glass material, a material containing silica or mica or a combination or said materials.

4. The chip module (1) according to any one of claims 1 to 3, wherein said protective layer (15) is provided as a discrete layer that is secured to the chip (10) by an adhesive layer (4).

5. The chip module (1) according to any one of claims 1 to 4, wherein said protective layer (15) includes particles of ceramic, glass and/or silica or mica, with said particles being incorporated in a binder to form an adhesive layer (4) that to secure the chip (10) to the contact plate (6).

6. The chip module (1) according to any one of the preceding claims, wherein the contact plate (6) comprises a recess (65) to receive said protective layer (15).

7. The chip module (1) according to any one of the preceding claims, wherein the protective layer (15) comprises apertures (16) through which conductive tracks (5) can extend to provide contact between the contact plate (6) and the chip (10).

8. The chip module (1) according to any one of the preceding claims, wherein the chip module (1) is made of a glass epoxy having two faces, one face being metallized and which has been etched to provide contact tracks (5) for the chip module (1) and the second face which forms the contact plate (6) and has output pads able to provide the contact between the chip (100) and an external device such as a data carrier reader.

9. The chip module (1) according to any one of the preceding claims, wherein an active face (3) of the chip (10) is angled with respect to an outer face (6a) of the contact plate (6).

10. The chip module (1) according to claim 9, wherein the outer face (6a) of the contact plate (6) is opposed to the active face (3) of the chip (10), and wherein the chip (10) is adhered to the contact plate (6) using an adhesive layer (4) which is thicker in one area than another area so that the active face () of the chip (10) is angled with respect to the outer face (6a) of the contact plate (6).

11. The chip module (1) according to any of claims 1 to 9, further comprising a chip support member (11) comprising a first face able to be attached to the contact plate (6), and a second face angled with respect to the first face able to be attached to the chip (10), so that the chip (10) is held angled with respect to the contact plate (6).

12. The chip module (1) according to any of claims 9 to 11, wherein the angle at which the chip (10) is angled relative to the contact plate (6) is more than 0 degrees, preferably between 1 and 15 degrees and more preferably is at a maximum of 10 degrees to the contact plate (6).

13. The chip module (1) according to any one of claims 1 to 12, wherein the chip module (1) is covered by an encapsulate that conforms to the dimension of a recess (9) intended to receive said chip module (1), so the chip module (1) can be push fitted into the recess (9).

14. The chip module (1) according to claim 13, wherein the encapsulate comprises a resin epoxy cresol novolac with one or more fillers based on amorphous or crystalline silica and alumina.

15. The chip module (1) according to any one of the preceding claims, wherein the protective layer (15) comprises at least one profiled face (150) either to reflect a laser directed at said profiled face (150) of the protective layer (15) or to deflect a drill applied to said profiled face (150) of the protective layer (15).

16. The chip module (1) according to claim 15, wherein the profiled face (150) of the protective layer (15) comprises a mirrored surface on at least part of said profiled face (150).

17. A data carrier comprising a support body (8) and a chip module (1) according to any one of the preceding claims incorporated therein.

18. A data carrier according to claim 17 including an antenna and where the data carrier is provided as a SIM card, a bank card, a payment card, an identity card or a passport.
